Europäisches Patentamt

**European Patent Office**

**Office européen des brevets**

(11) Veröffentlichungsnummer: **0 020 995**
**B1**

(12) **EUROPÄISCHE PATENTSCHRIFT**

(45) Veröffentlichungstag der Patentschrift:
15.06.83

(51) Int. Cl.³: **G 11 C 11/40**, G 11 C 11/24,
G 11 C 7/00

(21) Anmeldenummer: 80102653.5

(22) Anmeldetag: 13.05.80

(54) Verfahren und Schaltungsanordnung zur Selektion und Entladung der Bitleitungskapazitäten für einen hochintegrierten MTL Halbleiterspeicher.

(30) Priorität: 28.06.79 DE 2926050

(43) Veröffentlichungstag der Anmeldung:
07.01.81 Patentblatt 81/1

(45) Bekanntmachung des Hinweises auf die Patenterteilung:
15.06.83 Patentblatt 83/24

(84) Benannte Vertragsstaaten:
DE FR GB NL SE

(73) Patentinhaber: International Business Machines Corporation, Armonk, N.Y. 10504 (US)

(72) Erfinder: Heimeier, Helmut, Dr., Auf der Breite 23, 7033 Herrenberg 1 (DE)
Erfinder: Klein, Wilfried, Ulmenstrasse 86, 7031 Holzgerlingen (DE)
Erfinder: Klink, Erich, Max-Eyth-Strasse 34, 7036 Schönaich (DE)
Erfinder: Wernicke, Friedrich, Herdlauchring 6, 7036 Schönaich (DE)

(74) Vertreter: Rudolph, Wolfgang, Schönaicher Strasse 220, D-7030 Böblingen (DE)

(56) Entgegenhaltungen:
EP-A-0 004 871
EP-A-0 013 302
US-A-3 540 010
US-A-3 688 264
US-A-3 786 442
US-A-3 900 838
US-A-4 021 786
US-A-4 032 902
US-A-4 070 656
US-A-4 090 255
US-A-4 112 511
I. B. M. TECHNICAL DISCLOSURE BULLETIN, Band 21, Nr. 1, Juni 1978, Seiten 231—232 Armonk, U. S. A. WIEDMANN: »MTL Storage Cell«
IBM TECHNICAL DISCLOSURE BULLETIN, Band 13, Nr. 6, November 1970, Seiten 1705—1706 Armonk, U. S. A. WIEDMANN et al.: »Restore Circuitry for Bit/Sense System«

IEEE JOURNAL OF SOLID-STATE CIRCUITS, Band SC13, Nr. 5, Oktober 1978, Seiten 656—663 New York, U. S. A. KAWARADA et al.: »A Fast 7.5 ns Access 1K-Bit RAM for Cache-Memory Systems«
ELECTRONICS, Band 47, Nr. 9, 2. Mai 1974, Seiten 110—114 New York, U. S. A. GERSBACH: »Current Steering Simplifies and Shrinks 1k Bipolar RAM«
IEEE JOURNAL OF SOLID-STATE CIRCUITS, Band SC2, Nr. 4, Dezember 1967, Seiten 196—201 New York, U. S. A: IWERSEN: »Beam-Lead Sealed-Junction Semiconductor Memory with Minimal Cell Complexitiy«
IEEE JOURNAL OF SOLID-STATE CIRCUITS, Band SC6, Nr. 5, Oktober 1971, Seiten 297—300 New York, U. S. A. HENN: »Bipolar Dynamic Memory Cell«

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Verfahren und Schaltungsanordnung zur Selektion und Entladung der Bitleitungskapazitäten für einen hochintegrierten MTL-Halbleiterspeicher

Die Erfindung betrifft ein Verfahren und eine Schaltungsanordnung zur Selektion und Entladung der Bitleitungskapazitäten von hochintegrierten Halbleiterspeichern nach dem Oberbegriff des Patentanspruchs 1 bzw. 3.

Durch die DE-PS 2 511 518 sind ein Verfahren und eine Schaltungsanordnung zum Betreiben eines integrierten Halbleiterspeichers bekannt geworden, dessen Speicherzellen aus Flip-Flops mit bipolaren Transistoren und Schottky-Dioden als Lese-/Schreib-Ankoppelelemente bestehen und die als Lastelemente hochohmige Widerstände oder als Stromquellen geschaltete Transistoren benützen, deren Schreib-/Lesezyklen jeweils in mehreren Phasen ablaufen und die durch Pegeländerungen auf Wortleitungen und Bitleitungen selektiert werden, die zum Erhöhen der Schreib- und Lesegeschwindigkeit sowie zum Verringern der Verlustleistung die Entladung der Bitleitungen über die leitenden Speicherzellen-Transistoren vornehmen. Die Entladung der Bitleitung über diese leitenden Speicherzellen-Transistoren erfolgt dabei nach Masse. Während der Lesephase des Speichers werden die Bitleitungen nur geringfügig umgeladen, so daß der Umladestrom, der durch die Speicherzelle fließt, dabei sehr klein ist.

In den letzten Jahren hat auf dem Gebiet der logischen Verknüpfungsschaltungen und der integrierten Halbleiterspeichertechnik mit bipolaren Transistoren eine rege Entwicklung stattgefunden, die unter der Bezeichnung MTL (Merged Transistor Logic) oder auch I$^2$L (Integrated Injection Logic) Eingang in die Fachliteratur gefunden hat. Es wird hierzu beispielsweise auf die Aufsätze im IEEE Journal of Solid States Circuits, Band SC/7, Nr. 5, Okt. 1972, Seiten 340 bis 342 und 346 verwiesen. Entsprechende Vorschläge wurden auch in der US-PS 3 736 477 sowie in der weiteren US-PS 3 816 758 gemacht.

Diese Konzepte mit bipolaren Transistoren zeichnen sich durch kurze Schaltzeiten aus und sind zum Aufbau von extrem hochintegrierten Speichern und logischen Schaltungsverbänden besonders geeignet.

Speicher, die mit Speicherzellen aus bipolaren Transistoren aufgebaut sind, die eine MTL-ähnliche Struktur aufweisen, verlangen zur Selektion einer Speicherzelle die Umladung von Bitdaten- und/oder Steuerleitungskapazitäten. Der Spannungshub der Bitleitungen entspricht dabei ungefähr dem Spannungshub der selektierten Wortleitungen. Wie bereits in der DE-PS 2 511 518 beschrieben ist, werden die kapazitiven Entladeströme über die Speicherzellen der selektierten Wortleitung und über den Wortleitungstreiber nach Masse abgeführt. Dies hat jedoch bei einer größeren Anzahl von Speicherzellen innerhalb einer Matrix den Nachteil, daß der Flächenbedarf der Treiberschaltkreise, die elektrische Verlustleistung für jeden Treiber und die Verzögerungszeit bei der Selektion der Wortleitung unverhältnismäßig groß wird, so daß die Vorteile der verwendeten MTL-Struktur dadurch wieder zunichte gemacht würden.

Um diesen Nachteil zu beseitigen, wurde bereits in der EP-A-0 013 302 ein Verfahren zum Betreiben eines Halbleiterspeichers und eine Schaltungsanordnung vorgeschlagen, die diese Nachteile nicht mehr aufweisen. Das genannte Verfahren ist dadurch charakterisiert, daß eine an sich bekannte Kontrolle frühzeitig vor dem Selektieren für die Speichermatrix aufgrund eines Auswahlsignales gleichzeitig Steuersignale auf eine Entladeschaltung, die allen Speicherzellen gemeinsam ist, und auf Schalttransistoren abgibt, die daraufhin eingeschaltet werden, daß dadurch auf den Bitdaten- und -steuerleitungen die Entladeströme der Leitungskapazitäten durch die Schalttransistoren fließen und über die Entladeschaltung gemeinsam abfließen. Die genannte Schaltungsanordnung ist dadurch gekennzeichnet, daß die Bitleitungen innerhalb der Speichermatrix mit einer Entladeleitung verbunden sind, die ihrerseits mit einer Entladeschaltung verbunden ist und daß die Entladeschaltung und alle Wort- und/oder Bitleitungsschalttransistoren zur Steuerung über Leitungen mit einer Kontroll- oder Steuerlogik verbunden sind, die mit dem Selektionssignal des Speicherchips gesteuert wird.

Obwohl diese Entladeverfahren sowie die Schaltungsanordnungen zur Durchführung dieser Verfahren es gestatten, den minimalen Hub auf der Wortleitung zu verwenden, kapazitive Spitzenströme auf den Spannungsversorgungsleitungen zu verhindern und eine relativ hohe Integration erlauben, haben diese Lösungen folgende Nachteile:

Der Ablauf der Entladeoperation und der Selektionsoperation der Bitleitungen muß zeitlich nacheinander erfolgen. Der Anstieg des Abfühlstroms aus dem Abfühlschaltkreis nach der Selektion der Bitleitungen bestimmt mit maßgeblich die Zugriffszeit zur Speicherzelle. Die parallel arbeitenden Bit- und Wortleitungs-Schalttransistoren müssen am Ende der Selektionszeit alle eingeschaltet sein, so daß sich die Zugriffszeit des Speicherchips verlängert.

Die Zahl der erforderlichen Komponenten in den peripheren Schaltkreisen eines solchen Speichers ist jedoch noch sehr hoch. Außerdem ist das gelieferte Lesesignal von dem Gleichstrom abhängig, der von dem Lese-/Schreibverstärker geliefert wird.

Außerdem ist aus der US-PS 3 540 010 ein Halbleiterspeicher bekannt, dessen Speicherzellen aus Flip-Flops mit bipolaren Transistoren bestehen. Dieser Halbleiterspeicher enthält einen Lese-/Schreibschaltkreis und die Leitungskapazitäten werden vor oder während einer Schreib- bzw. Leseoperation entladen. Bei der Leseoperation wird gemäß dieser Patentschrift der kapazitive Strom der selektierten Zelle zugeleitet und zwar nur auf die Bitleitung, die mit der eingeschalteten Seite der Speicherzelle in Verbindung steht. Der kapazitive Strom fließt dann über die Speicherzelle und wird im Lese-/Schreibschaltkreis als Lesesignal wahrgenommen. Je nach Auslegung der Speicherzellen ist es möglich, den Speicher entweder nur mit Hilfe des von den Bitleitungskapazitäten bei der Selektion entstehenden dynamischen Stroms zu lesen oder zusammen mit einem vom Lese-/Schreibschaltkreis gelieferten Treiberstrom. Obwohl hier bereits gezeigt ist, daß Halbleiterspeicher mit bipolaren Transistoren durch die von Bitleitungskapazitäten bei der Selektion erzeugten Ströme allein oder zusammen mit einem Treiberstrom vom Lese-/Schreibschaltkreis, der mit den Bitleitungen verbunden ist, gelesen werden können, hat dieses Selektionsverfahren den Nachteil, daß ein Schreiben mit Hilfe dieser kapazitiven Ströme nicht möglich ist und auch das Lesen auf höchstintegrierte Speicher mit wesentlich kleinerem Spannungs- und Strompegel nicht ohne weiteres übertragen werden kann.

Aus der DE-OS 2 612 666 ist eine hochintegrierte, invertierende logische Schaltung mit einer, einen invertierenden Transistor bildenden Säulenfolge bekanntgeworden, der über ein Injektionsgebiet in der Nähe des Basis-Emitterübergangs durch Injektion von Ladungsträgern mit Betriebsstrom versorgt und an der Basis gesteuert wird, der dadurch gekennzeichnet ist, daß an das Injektionsgebiet eine Abfühlschaltung angeschlossen ist, über die der Leitzustand des invertierenden Transistors aufgrund des vom leitenden Transistor in das Injektionsgebiet rückinjizierten Stromes abgefühlt wird. Die Verwendung dieser Schaltung zum Aufbau einer MTL-Speicherzelle in Form eines aus zwei kreuzgekoppelten Schaltungen zusammengesetzten Flipsflops ist auch aus der DE-OS 2 612 666 bekannt.

Der Erfindung liegt deshalb die Aufgabe zugrunde, ein Verfahren und eine Schaltungsanordnung zur Selektion und Entladung der Bitleitungskapazitäten für einen hochintegrierten Halbleiterspeicher zu schaffen, dessen Speicherzellen aus Flip-Flops mit bipolaren Transistoren in MTL-Technik bestehen, die in Kreuzungspunkten von Wort- und Bitleitungen angeordnet sind und über Decodierer und Wortleitungstreiber selektiert werden, wobei die Bit- und Wortdecodierung nahezu parallel erfolgt und die Bitleitungskapazitäten bei der Selektion zum dynamischen Lesen entladen werden, wobei die kapazitiven Entladeströme nicht nur zum Lesen, sondern auch zum Schreiben benutzt werden sollen und zwar unter Berücksichtigung der Spannungs- und Strompegel auf den Wort- und Bitleitungen von hochintegrierten MTL-Speichern.

Die erfindungsgemäße Lösung für das Verfahren ergibt sich aus den Kennzeichen der Patentansprüche 1 und 2.

Die erfindungsgemäße Lösung der Schaltungsanordnung ergibt sich aus dem Kennzeichen des Patentanspruchs 3.

Der Vorteil des erfindungsgemäßen Verfahrens besteht in der wesentlichen Verbesserung des Lesesignals, das sich durch eine wesentlich höhere Flankensteilheit und absolute Größe auszeichnet.

Außerdem wird die Zahl der Komponenten in dem Lese-/Schreibschaltkreis, der jedem Bitleitungspaar zugeordnet ist, wesentlich reduziert, da hier keine Komponenten zur Bereitstellung eines Abfühl- und/oder Schreibgleichstroms mehr erforderlich sind. Die Zahl der Ansteuerleitungen für die Komponenten innerhalb des Lese-/Schreibschaltkreises verringert sich wesentlich. Störende Injektionsströme durch die Isolation zwischen selektierten und nicht selektierten Zellen werden wesentlich reduziert, da der neue Schaltkreis mit niedrigeren Strömen arbeitet. Bezüglich der Spannungspegel auf den Lese-/Schreib- und Bitleitungen ist der neue Lese-/Schreibschaltkreis äußerst unkritisch, da die beiden noch vorhandenen zum Schreiben dienenden Transistoren nie invers einschalten, bedingt dadurch, daß sie durch Schottky-Dioden gesperrt sind.

Die Erfindung wird nun anhand eines Ausführungsbeispiels, das in den Zeichnungen dargestellt ist, näher beschrieben.

Es zeigt

Fig. 1 einen Ausschnitt aus einer Speicherebene mit dem erfindungsgemäßen Lese-/Schreibschaltkreis;

Fig. 2 ein Zeitdiagramm für die Lese- und Schreiboperationen, die in der Schaltungsanordnung nach Fig. 1 ablaufen und

Fig. 3 ein detailliertes Ersatzschaltbild für die Speicherzellen innerhalb einer Kolonne der Speicherebene.

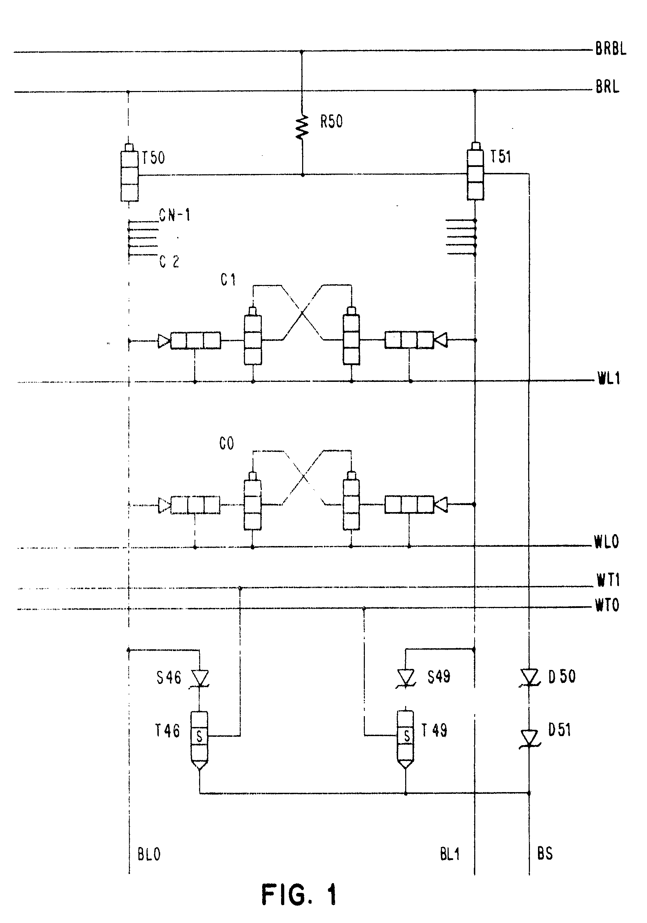

Das in Fig. 1 gezeigte Schaltbild stellt einen Ausschnitt aus einer Speicherebene in integrierter Technik dar. Im unteren Teil der Schaltungsanordnung ist der neue Lese-/Schreibverstärker dargestellt. Es besteht aus den beiden Schottky-geklemmten Transistoren T46 und T49 mit den Schottky-Kollektor-Kontakten S46 bzw. S49. Die Basis des Transistors T46 ist mit einer Leitung WT1 verbunden, die für alle Lese-/Schreibverstärker einer Speicherebene gemeinsam vorhanden ist und die Basis des Transistors T49 ist mit einer Leitung WT0 verbunden, die für alle Lese-/Schreibverstärker einer Speicherebene ebenfalls gemeinsam vorhanden ist. Die Emitter der beiden Transistoren T46 und T49 sind über eine gemeinsame Leitung mit einer Bit-Selektionsleitung BS verbunden, die über zwei in Reihe geschaltete Schottky-Dioden D50 und D51 mit der Basis des einen Bitschalters T51 verbunden ist. Dieser den Bitschalter für die Bitleitung BL1 darstellende Transistor T51 ist mit der Bitleitung BL1 verbunden, der Transistor T50 mit der Bitleitung BL0, während die andere Elektrode beider mit einer Bit-Referenzleitung BRL auf der Speicherebene verbunden ist. Außerdem werden die Basen beider

0 020 995

Transistoren T50 und T51 über einen Widerstand R50, der mit einer weiteren Referenzleitung BRBL verbunden ist, mit einem Strom versorgt, der diese Transistoren während der Ruhezeit in Sättigung hält.

Im mittleren Teil der Fig. 1 sind zwei Speicherzellen C0 und C1 innerhalb des Bitleitungspaares BL0, BL1 dargestellt. Die angedeuteten waagerecht verlaufenden Leitungen oberhalb der Speicherzelle C1 sollen nur andeuten, daß innerhalb dieses Bitleitungspaares BL0, BL1 in der Praxis N Speicherzellen angeordnet sind.

Außerdem sind in der Fig. 1 für jede Speicherzelle C0, 1, . . . Wortleitungen WL vorhanden, wovon in diesem Schaltbild jedoch nur die Wortleitungen WL0 und WL1 für die Speicherzellen C0 und C1 dargestellt sind. Außerdem soll noch erwähnt sein, daß an die Bitleitungen BL0 und BL1 zum Abfühlen der gespeicherten Informationen ein nicht dargestellter bekannter Differenzverstärker angeschlossen ist, der für alle Zellen innerhalb eines Bitleitungspaares BL0, BL1 gemeinsam ist. Die Aufgabe der Schottky-Dioden D50, D51 und des Widerstands R50 bestehen in der Bereit- und Einstellung der Ruhe- und Betriebspotentiale während der einzelnen Speicheroperationen auf bekannte Art und Weise.

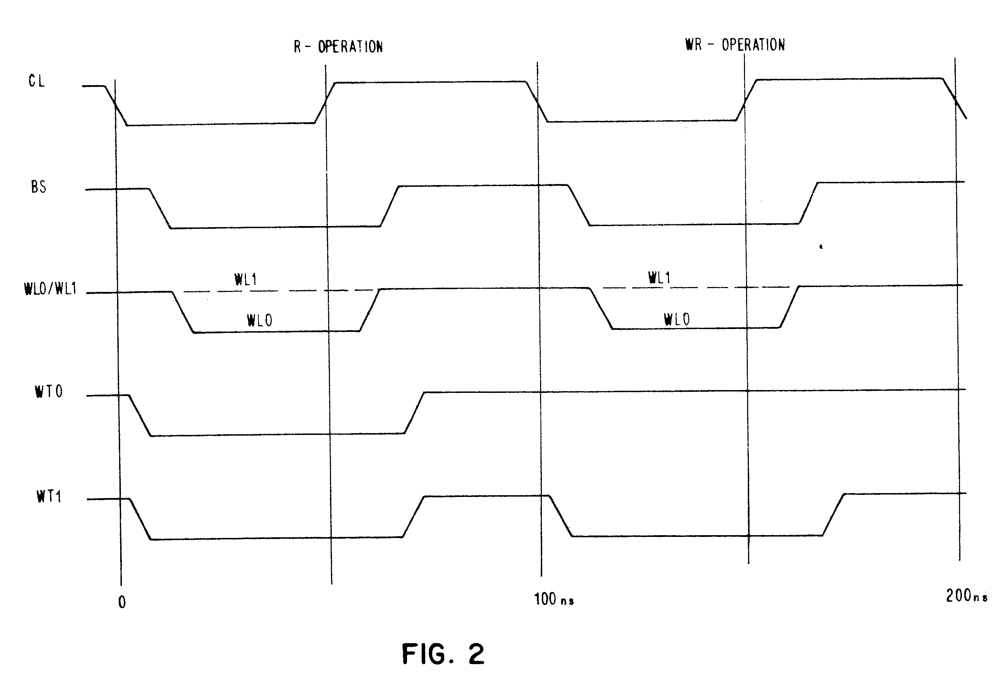

Im folgenden sei nun anhand des in Fig. 2 gezeigten Zeitdiagramms für je einen Lese- und Schreibzyklus, in der Figur als R-Operation bzw. WR-Operation gekennzeichnet, die Wirkungsweise des in Fig. 1 gezeigten Schaltbildes näher erklärt.

Zunächst wird angenommen, daß sich der Speicher im Ruhezustand befindet, d. h., daß alle Potentiale und Ströme sich so eingestellt haben, daß nur ein sehr kleiner Leistungsverlust auftritt. Die Ströme für die Bitleitungen BL0 und BL1 werden über die als Bitleitungsschalter dienenden Transistoren T50 und T51 geliefert. Diese beiden Transistoren T50 und T51 sind invers betrieben und tief gesättigt, wodurch gewährleistet ist, daß sich die Bitleitungspotentiale VBL0 und VBL1 nur um einen geringen Betrag voneinander unterscheiden (typisch 3 mV für ein eingespeichertes Bitmuster unter kritischsten Bedingungen). Die Wortleitungspotentiale VWL0, VWL1, . . ., VWL(N-1) liegen um VBE (typisch 600 mV) unter dem Bitleitungspotential.

Im folgenden soll nun angenommen werden, daß die in Fig. 1 dargestellte Speicherzelle C0 zum nachfolgenden Lesen selektiert werden soll. Die bitseitige Selektion der Speicherzelle C0 erfolgt durch Herabziehen des Potentials auf der Leitung BS (siehe Zeitdiagramm nach Fig. 2). Dadurch werden die beiden als Bitleitungsschalter dienenden Transistoren T50 und T51 abgeschaltet und der Ruhestrom wird unterbrochen. Die Selektion der Speicherzelle C0 in Fig. 1 auf der Wortseite erfolgt durch Absenken des Potentials auf der Wortleitung WL0.

Wenn nun das Potential auf der Wortleitung WL0 sprungartig herabgezogen wird, bilden die Parallelschaltungen der Injektorkapazitäten der nicht-selektierten Zellen und der Bitleitungs-Metall-Kapazitäten CS0 und CS1

$$CBL0 = CE10 + CE20 + \ldots + CE(N-1)0 + CS0$$
$$CBL1 = CE11 + CE21 + \ldots + CE(N-1)1 + CS1$$

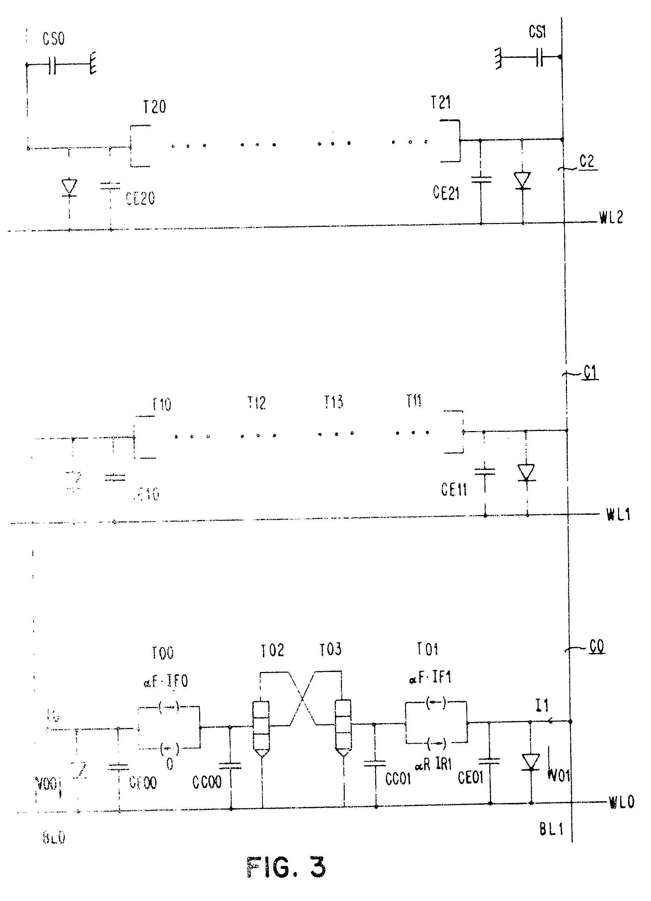

mit den Injektorkapazitäten CE00 und CE01 der selektierten Speicherzelle C0 einen kapazitiven Spannungsteiler, wie aus der Fig. 3 zu ersehen ist.

In die beiden Eingangskapazitäten CE00 und CE01 fließt impulsförmig eine Ladung $\Delta Q$, wodurch sich die Injektorspannungen der selektierten Speicherzelle C0 erhöhen. Analysen bei praktischen Versuchen ergaben, daß sich bei einem Wortleitungshub von

$$\Delta VWL \approx 400 \text{ mV}$$

eine Aufladung der Injektorkapazitäten um

$$\Delta Q \approx 1 \text{ pAs}$$

bei einer Erhöhung der Injektorspannungen um

$$\Delta V \approx 230 \text{ mV}$$

ergibt.

Die in die Injektoren fließenden Ladungen $\Delta Q$ entsprechen über den Taktzyklus tCL = 50 ns gemittelt, einem mittleren Lesestrom von I0 = I1 = $\Delta Q$/tCl ( $\approx$ 20 $\mu$A).

Der Ausgleichsvorgang für $\Delta Q$ nach dem Herabziehen des Potentials auf der Wortleitung, z. B. WL0, ist äußerst komplex und wird anschließend anhand der Fig. 3 näher erklärt.

Anfangs bewirken die von den Injektorkapazitäten CE00 und CE01 zu den inneren Zellknoten injizierten Entladungsströme eine Aufladung der dargestellten Kapazitäten CC00 und CC01. Dabei steigt die Basis-Emitterspannung beider NPN-Transistoren T02 und T03 an. Auf der sich im Aus-Zustand befindlichen Seite der Speicherzelle C0, hier der Transistor T02, erreicht die Spannung, ausgehend von ca. 20 mV kurzzeitig einen Wert von ca. 400 mV, worauf sie sehr rasch wieder abfällt,

4

wenn die Basis-Emitter-Kapazität CC01 des Transistors T03 so weit aufgeladen ist, daß der Entladestrom auf der sich im Aus-Zustand befindlichen Seite der Speicherzelle C0 übernommen werden kann.

Auf der sich im Ein-Zustand befindlichen Seite, d. h., in Fig. 3 am Transistor T03, steigt die Spannung von ca. 600 mV auf ca. 800 mV, um dann langsam wieder abzufallen.

Das Lesesignal ergibt sich aus dem unterschiedlichen Abbau der Ladungen der sich im Aus-Zustand und der sich im Ein-Zustand befindlichen Seite der Speicherzelle C0. Der Entladestrom auf der sich im Aus-Zustand befindlichen Seite ist der Kollektorstrom des sich im Ein-Zustand befindlichen NPN-Transistors T03. Diese Entladung verläuft sehr rasch. Auf der sich im Ein-Zustand befindlichen Seite entspricht dem der Basisstrom des sich im Ein-Zustand befindlichen NPN-Transistors T03. Dieser ist um die Stromverstärkung $\beta u$ niedriger als der Kollektorstrom. Der durch den Basisstrom nicht entladene Teil von $\Delta Q$ verbleibt als Speicherladung im PNP-Transistor T01 auf der sich im Ein-Zustand befindlichen Seite. Dieser Teil fällt mit der Speicherzeitkonstanten $\tau S$, die typischerweise bei 30 ns liegt, ab. Der größeren Ladung auf der sich im Ein-Zustand befindlichen Seite entspricht eine höhere Injektorspannung.

Somit ist gezeigt worden, daß lediglich durch die kapazitiven Ströme auf den Bitleitungen BL0 und BL1, d. h. ohne jegliche zusätzlich generierte Ströme durch die Lese-/Schreibschaltung das Lesen der gespeicherten Information in der Speicherzelle C0 möglich ist.

In Fig. 3 sind außerdem der Vollständigkeit halber noch die Ersatzkomponenten der Speicherzellen C1 und C2 angedeutet. Im nachfolgenden soll noch kurz auf die Schreiboperation und die dabei auftretenden Ströme eingegangen werden.

Zum Schreiben wird einer der beiden im Lese-/Schreibschaltkreis vorhandenen Transistoren T46 bzw. T49 aktiviert, d. h. in den Ein-Zustand versetzt. Mit anderen Worten, die Bitleitung BL0 wird entladen, wenn der Transistor T46 eingeschaltet wird und die Bitleitung BL1 wird entladen, wenn sich der Transistor T49 im Ein-Zustand befindet. An der jeweiligen, mit der Bitleitung BL0 oder BL1 verbundenen Eingangskapazität der Speicherzelle C0 bildet sich, wie beim Lesen bei Absenkung des Wortleitungspotentials VWL0, die Ladung Q aus. Wenn zu diesem Zeitpunkt, der sich bisher im Ein-Zustand befindliche Transistor den in den Kollektor fließenden Strom nicht mehr übernehmen kann, weil der mit ihm integrierte PNP-Transistor keinen Basisstrom mehr liefert, kippt die Speicherzelle in den anderen Zustand um, d. h., die gewünschte binäre Null bzw. binäre Eins ist eingeschrieben.

Auch hier wurde klar gezeigt, daß außer den kapazitiven Strömen zum Schreiben einer Information in den Speicher keine weiteren Ströme erforderlich sind und gerade deshalb ein sehr schnelles und sauberes Schalten möglich ist. Aus dem Schaltbild nach Fig. 1 geht auch klar hervor, daß der technische Aufwand für den Lese-/Schreibschaltkreis bei der Verwendung nur kapazitiver Ströme zum Lesen und/oder Schreiben von Informationen äußerst gering ist. Ein weiterer Vorteil besteht darin, daß wenig Steuerleitungen erforderlich sind, so daß eine sehr hohe Integrationsdichte erzielbar ist.

Die Treiberschaltungen und Decodierschaltungen auf der Bit- bzw. auf der Wortseite des Speichers sind weder dargestellt noch werden sie beschrieben, weil sie in der Technik hinlänglich bekannt sind und zur Erklärung der vorliegenden Erfindung nicht erforderlich sind.

**Patentansprüche**

1. Verfahren zur Selektion und Entladung der Bitleitungskapazitäten für einen hochintegrierten Halbleiterspeicher, dessen Speicherzellen (C) aus Flip-Flops mit bipolaren Transistoren in MTL-Technik bestehen, die in Kreuzungspunkten von Wort- und Bitleitungen (WL, BL) angeordnet sind und über Decodierer und Wortleitungstreiber selektiert werden, wobei die Bit- und Wortdecodierung nahezu parallel erfolgt und die Bitleitungskapazitäten bei der Selektion zum dynamischen Lesen entladen werden, und ein Lese-/Schreibschaltkreis vorhanden ist, der das Differenzsignal auf den Bitleitungen zum Lesesignal verstärkt, dadurch gekennzeichnet, daß auch das Schreiben der Speicherzellen (C) mittels des Stromes erfolgt, der nur durch die Entladung der Kapazitäten des selektierten Bitleitungspaares (BL0, BL1) erzeugt wird, daß zum Lesen auf beide Seiten der Zelle ein Strom $(\alpha F \cdot IF0, \alpha F \cdot IF1)$, der nur durch die Entladung der Kapazitäten des selektierten Bitleitungspaares (BL0, BL1) erzeugt wird, gegeben wird, wobei nur auf der eingeschalteten Seite (T03) der Speicherzelle (CO) ein Rückinjektionsstrom-Signal $(\alpha R \cdot IR1)$ erzeugt wird, das durch den Lese-/Schreibschaltkreis zum Lesesignal verstärkt wird und daß die Speicherzellen (C) während der Ruhezeit mit einem Strom über die Bitleitungen (BL0, BL1) versorgt werden, während der Lese- oder Schreibzeit hingegen das selektierte Bitleitungspaar (BL0, BL1) von der Stromversorgung mittels der Bitschalter (T50, T51) isoliert wird.

2. Verfahren nach Anspruch 1, dadurch gekennzeichnet, daß die Entladeströme aus Bitleitungs- und Injektor-Sperrschicht-Kapazitäten bei der selektierten Speicherzelle (z. B. C0) Injektor-Diffusions-Kapazitäten laden, worauf die Basis-Emitter-Spannung des zugehörigen NPN-Transistors (T03) ansteigt und von der Basis des NPN-Transistors (T03) ein Rückinjektionsstrom $(\alpha R \times IR1)$ in den Injektor (I1)

fließt, der auf den Bitleitungen (BL0, BL1) ein unterschiedliches Potential generiert, das dem Lese-/Schreibschaltkreis zugeführt wird.

3. Schaltungsanordnung zur Durchführung des Verfahrens nach den Ansprüchen 1 und 2, dadurch gekennzeichnet, daß die Bitleitungen (BL0, BL1) je einen als Bitleitungsschalter dienenden Transistor (T50, T51) aufweisen, die invers betrieben werden und gesättigt sind, daß zur bitseitigen Selektion einer Speicherzelle (z. B. C0) eine Bitselektionsleitung (BS) vorhanden ist, deren Potential beim Selektieren herabgezogen wird, wodurch die beiden als Bitleitungsschalter dienenden Transistoren (T50 und T51) abgeschaltet werden, der Ruhestrom unterbrochen wird, daß mit den Bitleitungen (BL0 und BL1) zwei Schottky-geklemmte Transistoren (T46 und T49) mit Schottky-Kollektorkontakten (S46 und S49) verbunden sind, deren Basen jeweils mit einer Schreib-/Leseleitung (WT1 bzw. WT0) verbunden sind und deren Emitter gemeinsam mit der Bitselektionsleitung (BS) verbunden sind.

## Claims

1. Method for selecting and discharging the bit line capacitances for a highly integrated semiconductor storage, whose storage cells (C) consist of flip-flops with bipolar transistors in MTL technology which are arranged at crossings of word and bit lines (WL, BL) and are selected by decoders and word line drivers, wherein bit and word decoding is effected almost in parallel and the bit line capacitances are discharged upon selection for dynamic reading, and a read/write circuit is provided which amplifies the difference signal on the bit line to form a read signal, characterized in that writing of the storage cells (C) is also effected by means of the current which is generated by discharging only the capacitances of the selected bit line pair (BL0, BL1), that for reading, a current ($\alpha F \times IF0$, $\alpha F \times IF1$), generated by discharging only the capacitances of the selected bit line pair (BL0, BL1), is applied to both sides of the cell, wherein a reinjection current signal ($\alpha R \times IR1$), amplified by the read/write circuit fo form a read signal, is generated only on the switched on side (T03) of the storage cell (C0), and that during the standby time, the storage cells (C) receive current through the bit lines (BL0, BL1), whereas during the read or the write time, the selected bit line pair (BL0, BL1) is isolated form the current supply by means of the bit switches (T50, T51).

2. Method according to claim 1, characterized in that the discharge currents from bit line and injector depletion layer capacitances charge injector diffusion capacitances at the selected storage cell (e. g., C0), causing a rise of the base-emitter voltage of the appertaining NPN transistor (T03) and a reinjection current flow ($\alpha R \cdot IR1$) from the base of the NPN transistor (T03) to the injector (I1) which generates a different potential on the bit lines (BL0, BL1) which is fed to the read/write circuit.

3. Circuit arrangement for implementing the method according to claims 1 and 2, characterized in that the bit lines (BL0, Bl1) are each provided with a transistor (T50, T51) acting as a bit line switch, the transistors being inversely driven and saturated, that for the bit side selection of a storage cell (e. g., C0), a bit selection line (BS) is provided, whose potential is used for selection, so that the two transistors (T50 and T51) acting as bit line switches are switched off, that the bit lines (BL0 and BL1) are connected to two Schottky clamped transistors (T46 and T49) with Schottky collector contacts (S46 and S49), whose bases are each connected to a read/write line (WT1 and WT0, respectively) and whose emitters are jointly connected to the bit selection line (BS).

## Revendications

1. Procédé de sélection et de décharge des capacités de lignes de bits d'une mémoire à semi-conducteurs à haute intégration dont les cellules de mémoire (C) sont constituées de flip-flops à transistors bipolaires en technique MTL, sont situés aux points d'intersection des lignes de mots et des lignes de bits (WL, BL) et sont sélectionnés par l'intermédiaire de décodeurs et d'excitateurs de ligne de mots, le décodage des bits et des mots s'effectuant sensiblement en parallèle, les capacités de la ligne de bits étant déchargées lors de la sélection pour la lecture dynamique, et un circuit de lecture/écriture amplifiant le signal différentiel sur la ligne de bit pour former le signal de lecture, caractérisé par le fait que l'écriture des cellules de mémoire (C) s'effectue au moyen du courant produit uniquement par la décharge des capacités de la paire de lignes de bits sélectionnée (BL0, BL1), par le fait que, pour la lecture, on applique sur les deux côtés de la cellule un courant ($\alpha F \times IF0 \times \alpha F \times IF1$) produit par la seule décharge des capacités de la paire de lignes de bits sélectionnée (BL0, BL1), par le fait qu'un signal d'injection de courant en retour ($\alpha R \times IR1$) qui est amplifié en signal de lecture par le circuit de lecture/écriture n'est généré que sur le côté sous tension (T03) de la cellule de mémoire (C0) et par le fait que les cellules de mémoire (C), pendant le temps de repos, sont alimentées en courant par l'intermédiaire des lignes de bits (BL0, BL1) alors que, pendant le temps de lecture ou d'écriture, la paire de lignes de bits sélectionnée (BL0, BL1) est isolée de l'alimentation de courant au moyen des commutateurs de bits (T50, T51).

2. Procédé selon la revendication 1 caractérisé par le fait que les courants de décharge des capacités de ligne de bit et des capacités des couches d'appauvrissement de l'injecteur chargent les capacités de diffusion de l'injecteur pour la cellule de mémoire sélectionnée (par exemple C0), ce qui provoque une montée de la tension base-émetteur du transistor NPN correspondant (T03) et le passage d'un courant d'injection en retour ($\alpha R \times IR1$) depuis la base du transistor NPN (T03) vers l'injecteur (I1), ce qui engendre, sur les lignes de bits (BL0, BL1), un potentiel différent qui est transmis au circuit de lecture/écriture.

3. Circuit pour réaliser le procédé défini dans la revendication 1 ou 2, caractérisé par le fait que les lignes de bits (BL0, BL1) comprennent chacune, en guise de commutateur de ligne de bits, ces transistors (T50, T51) étant commandés en inverse et saturés par le fait que la sélection côté bit d'une cellule de mémoire (par exemple C0) se fait au moyen d'une ligne de sélection de bit (BS) dont le potentiel est utilisé pour la sélection, les deux transistors (T50 et T51), servant de commutateurs de ligne de bits, étant hors tension et le courant de repos étant interrompu, par le fait que les lignes de bits (BL0 et BL1) sont reliées à deux transistors (T46 et T49) munis d'une diode Schottky d'anti-saturation, comportant des contacts collecteurs de Schottky (S46 et S49) et dont les bases sont reliées à une ligne d'écriture/lecture (WT1 ou WT0) et dont les émetteurs sont reliés ensemble à la ligne de sélection de bit (BS).

FIG. 1

FIG. 2

FIG. 3